# EUROPEAN PATENT APPLICATION

(11) **EP 0 926 740 A2**
(43) Date of publication of application: **30.06.1999**
(21) Application number: 98650089.0
(22) Date of filing: 17.12.1998
(51) Int. Cl.: H01L 29/74

(54) **A transient voltage suppressor**

(30) Priority: 23.12.1997 IE 970927
(71) Applicant: National University of Ireland, Cork, Cork (IE)
(72) Inventor: Murray, Anthony, San Diego, California 92124 (US); Lane, William Alan, Waterfall, County Cork (IE); Walsh, Philip, Tullamore, County Offaly (IE); Hayes, John, Cork (IE)
(74) Representative: O'Brien, John Augustine

(57) **Abstract**

A breakover diode (1) has a vertical thyristor structure having an anode emitter layer (10), a base layer (11), a base layer (12), and a cathode emitter layer (13). The diode (1) also includes an auxiliary junction (J2²) formed by lateral first and second regions 20 and 21 having p- and n+ doping respectively. The n+ region 21 has a high doping concentration so that the auxiliary junction (J2²) breaksdown before other junctions in the vertical thyristor structure, thus allowing simple setting of diode parameters by fabricating in the lateral regions.

## Description

### Field of the Invention

The invention relates to a transient voltage suppressor or surge protection device and to a method of producing such a device. More particularly, the invention relates to such a device of the breakover diode type.

### Prior Art Discussion

Such diodes comprise a thyristor structure. such as an n+/p+/n-/p+ structure, without a gate. They operate on the principle of avalanche breakdown at a forward blocking or triggering voltage (V_{BF}) causing regeneration if the sum of the transistor gains is at least unity.

The sequence for regeneration includes a gradual increase in current with voltage until avalanche breakdown occurs at V_{BF}. There is then a rapid rise in current with voltage until, a breakover voltage V_{BO}, the voltage suddenly drops to a much lower level and current dramatically increases.

In common design of breakover diode. I_{BO} is a function of the transistor gains. This causes a problem because V_{BF} is a function of the doping in the thyristor layers and hence of the starting of wafer resistivity which affects the transistor gains. Because of this, setting both I_{BO} and V_{BF} independently is extremely difficult, particularly because control of other device parameters such as I_{H} is important.

### SUMMARY OF THE INVENTION

According to the invention there is provided a breakover diode comprising a vertical layer thyristor structure between an anode and a cathode, characterised in that the diode further comprises a lateral auxiliary junction formed by a lateral first region adjoining a thyristor layer having the same doping type, and a lateral second region adjoining the first region and being of the other doping type. the doping of the auxiliary junction being such that avalanche breakdown occurs firstly at the auxiliary junction.

Thus, the breakdown characteristics are set laterally of the thyristor and are therefore easier to set. and may be set independently of the thyristor structure.

In one embodiment, the auxiliary junction forms a current path at breakdown linking the central layers of the thyristor.

In one embodiment, the second region of the auxiliary junction adjoins a thyristor layer of the same doping type.

In another embodiment, the first region has a lower doping level than the adjoining thyristor layer.

Preferably, the second region has a higher doping level than the adjoining thyristor layer.

In a further embodiment, the first and second regions are fabricated on an n- thyristor layer, the first region has p- doping, and the second region has n+ doping.

In a further embodiment, the lateral first region has a doping concentration in the range of 1 x 10¹² to 1 x 10¹⁷/cm³ and the lateral second region has a doping concentration in the range of 1 x 10¹⁶ to 1 x 10²²/cm³.

According to another aspect, the invention provides a method of producing a breakover diode comprising the steps of:-
providing a doped substrate as a thyristor layer; and
fabricating vertical layers on the substrate to form a vertical thyristor structure, and lateral regions to form an auxiliary junction adjoining two or more thyristor layers. the lateral regions being doped to break down before junctions in the thyristor structure.

In one embodiment, the lateral first and second regions are fabricated on the substrate thyristor layer.

In one embodiment. the lateral regions comprise a first region adjoining a thyristor layer having the same doping type and a second region adjoining the first region and being of the other doping type.

In another embodiment, the substrate is a central thyristor layer.

Preferably, the lateral first region is fabricated independently.

In a further embodiment, the lateral second region is fabricated together with a cathode emitter layer of the thyristor.

In the latter embodiment, the lateral second region preferably has the same doping type and concentration as the cathode emitter layer.

### DETAILED DESCRIPTION OF THE INVENTION

### Brief Description of the Drawings

The invention will be more clearly understood from the following description of some embodiments thereof, given by way of example only with reference to the accompanying drawings in which:-
Fig. 1 is a diagrammatic cut-away perspective view of a breakover diode of the invention;
Figs.2 to 4 are plots illustrating doping profiles in the diode;
Figs. 5 to 8 inclusive are simplified current/voltage plots in which different phases of operation of the diode are illustrated; and
Figs. 9 and 10 are plots showing parameters of operation of the diode.

### Description of the Embodiments

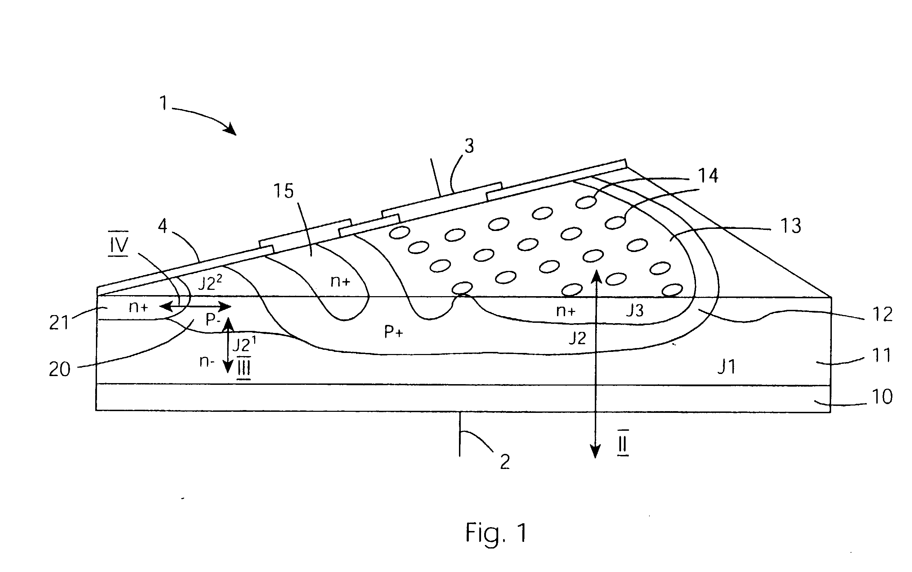

Referring to Fig. 1 there is shown a cut-away sector of a breakover diode 1 of the invention. The diode 1 comprises an anode contact 2 and a cathode contact 3. Between these contacts there is a p+ anode emitter layer 10, an n- base layer 11, a p+ base layer 12, and an n+ cathode emitter layer 13. The layers 10, 11, 12, and 13 are fabricated in a vertical thyristor structure.

The diode 1 also comprises a shorting dot array 14 in the cathode emitter layer 13. An amplifying gate section (AGS) 15 is also fabricated alongside the cathode emitter layer 13.

In addition, the diode 1 comprises an auxiliary junction comprising a lateral first region 20 of p-doping and a lateral second region 21 of n+ doping. The second region 21 is highly doped, whereas the first region 20 has a relatively low doping concentration. In more detail, the relative doping concentrations are as follows:-
n+ > p-,
n+ > n-,
n+ p+, and
p+ > n-.

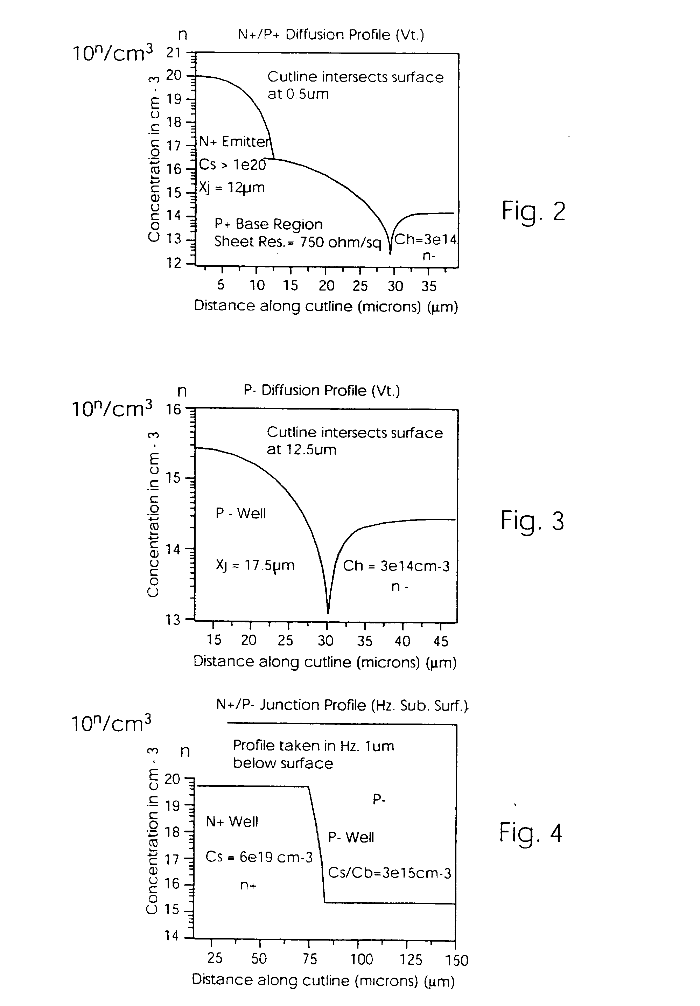

In more detail. the plot of Fig. 2 is a doping profile vertically through the diode in the direction of the arrow II, in the vertical thyristor structure. This plot also indicates the doping of the n+ lateral second region 21 because it is the same as the n+ layer 13 for ease of fabrication.

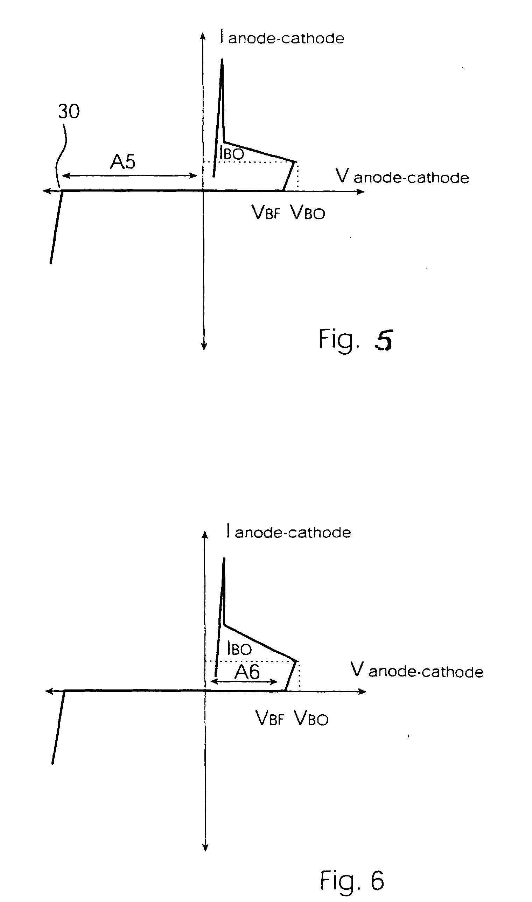

Fig. 3 is a plot of the vertical profile indicated by the arrow III between the p- region 20, and the n- layer 11.

Fig. 4 is a plot of the horizontal profile indicated by the arrow IV between the n+ region 21 and the p- region 20.

It will be appreciated that the n+ region 21 is doped approximately four orders of magnitude greater than the p- region 20. Also, the p- region is doped one order of magnitude greater than the underlying n- layer 11.

While the doping concentration levels illustrated have been found to be effective, levels within the range 1 x 10¹⁶ to 1 x 10²² /cm³ for the n+ region and the range 1 x 10¹² to 1 x 10¹⁷/cm³ for the p- region are expected to yield good results.

For fabrication of the diodes, the n- layer 11 is a substrate wafer onto which the p+ layer 12 is fabricated. The p+ cathode emitter layer 10 is fabricated on the other side of the n-wafer. The p- lateral first region 20 is then fabricated. Fabrication of all of the p type layers is by the implant dosing technique. The top n+ layer 13 and the n+ lateral second region 21 are then grown in a single operation. It will be appreciated that the only additional process operation required is adding the p- region 20.

Referring also to Figs. 5 to 10 inclusive, operation of the diode I is now described. Consider firstly the plot of Fig. 5. This plot and the plots of Figs. 6 to 8 inclusive show the anode-cathode current/anode-cathode voltage performance in simplified format. The plot is the same for all of Figs. 5 to 8, however, each plot includes an arrow A5 to A8 respectively which indicates the region of operation being described.

Referring to Fig. 5, a reverse blocking and reverse breakdown region is shown. In this region a negative voltage is applied at the anode 2. As this voltage increases a junction J1 between the p+ and n- layers 10 and 11 is reverse biased and a depletion region is generated at this junction. The junction between the n- layer 11 and the p+ layer 12 is referred to as J2, that between the n- layer 11 and the lateral first region 20 J2¹, and that between the lateral second region 21 and the lateral first region 20 has J2². These regions are all forward biased. Finally. a junction J3 between the p+ layer 12 and the n+ cathode layer 13 is reverse biased and so a depletion region is generated at this junction also. Negligible current flows while these depletion regions exist. however, when the electric field reaches a critical value avalanche breakdown of the junction Jl occurs, thereby allowing current to flow across J1 through the forward biased junction J2 and the cathode contact 3.

The diode 1 is normally connected with the anode at a higher voltage than the cathode. However, if this is not the situation, the design may be symmetrical for bi-directional operation.

Referring now to Fig. 6. a forward blocking region A6 is now described. In this case there is a positive voltage applied at the anode 2 relative to the cathode causing depletion regions to form across the junctions J2, J2¹, and J2². The junctions Jl and J3 are forward biased. Spread of the depletion regions is a function of the doping concentrations at the junctions J2, J2¹, and J2². The lateral second region 21 has a high doping concentration and therefore the depletion region at the junction J2² is narrower and there is a higher electric field at this junction.

For the stage A6. illustrated in Fig. 6. negligible current flows as the voltage across the diode I increase to a threshold level above which protection is required.

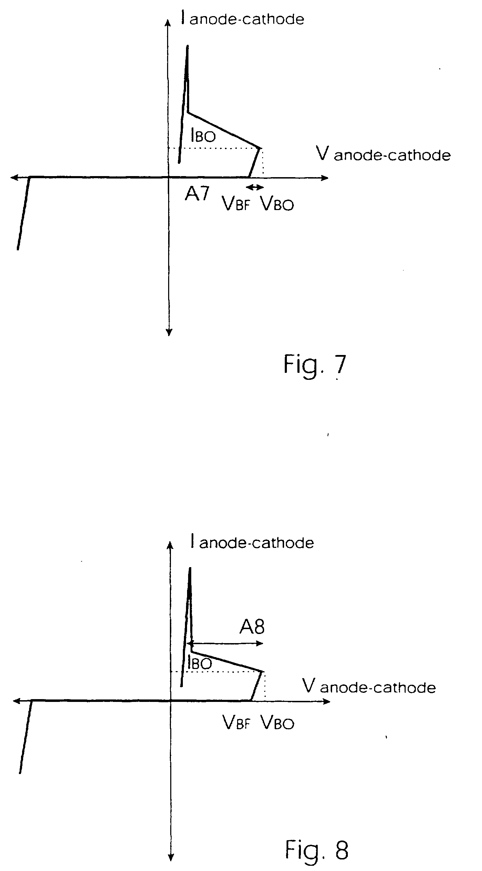

Referring now to Fig. 7. a forward breakdown stage is now described. This stage is indicated by the arrow A7 of Fig. 7. Eventually. the electric field across one of the junctions J2, J2¹, and J2² will reach a value to cause avalanche breakdown in that area. Because of the high concentration in the n+ second lateral second region 21. breakdown will occur firstly at the junction J2². The particular voltage at which this junction breaks down may be set by setting the dopant concentration of the p- lateral first region 20. This is very easily achieved using conventional fabrication techniques without affecting the main pnpn thyristor structure. The peak dopant concentrations on either side of the J2² junction are near the surface and so it is at the surface that the junction normally breaks down. Therefore, these regions may be referred to as a surface breakdown trigger mechanism. The voltage at which breakdown occurs is referred to as a V_{BF}.

Referring now to Fig. 8. a stage indicated by the arrow A8 from forward breakdown to an on-stage is now described. When the junction J2² breaks down, current is free to flow from anode to cathode through the forward biased junction J1, across the n- layer 11, through the lateral second and first regions 21 and 20 and into the p+ thyristor layer 12 and subsequently into the cathode emitter layer 13. Therefore, the lateral first and second regions effectively link the central thyristor layer 11 and 12 by forming a breakdown current path between them. When a breakover current, I_{BO} is reached, the voltage suddenly decreases from a breakover voltage level V_{BO} during an unstable transition period indicated by the arrow A8. The current which arose during the stage A4, acts as a base drive current for the upper npn transistor and therefore enhances the anode current. Also, when there are cathode shorts. current flow beneath the n+ has an associated voltage drop which will turn the n+p+ diode on when it reaches a sufficiently high level.

This is equivalent to raising the current gain of the npn transistor. When these two effects result in the combined gain of the two transistors pnp and npn to equal unity, then current can flow freely and vertically through the device. The inner n+ layers turn on first and over a short time period the flow spreads to the outer areas. Once the n+ layers turn on, thyristor action begins and this current level is the breakover current I_{BO}. I_{BO} is determined by the p+ layer sheet reistance and the radial dimensions of the n+ layer 13. Thus, it may be set by varying the dimensions and not the p+ base doping profile. The amplifying gate 15 can speed up the process because its radial dimensions can be chosen so that it turns on first and amplifies the gate current. However, the amplifying gate section 15 is not essential to the diode.

When the main thyristor turns on. the lowest resistance path is through the thyristor itself and the current will stop flowing through the junction J2² so that it reverts to a reverse biased state. The thyristor is now in its low resistance on state. The thyristor will turn off and revert to its blocking state when the current is reduced so that the combined gains of the two transistors becomes less than 1.

It will thus be appreciated that the invention provides a breakover diode which allows simple and independent setting during fabrication of important parameters. In more detail. V_{BF}. is set in a single process step by setting the implant dose of the lateral p- first region 20. This control is independent of the vertical thyristor structure. The switching point parameters V_{BO} and I_{BO} may be set independently of the triggering voltage by fabrication of the geometry of the cathode emitter layer 13. Thus, the invention allows independent "tuning" of parameters by process control. For example, the p- region 20 and the p+ layer implants may be varied to produce a range of forward blocking voltages and breakover currents.

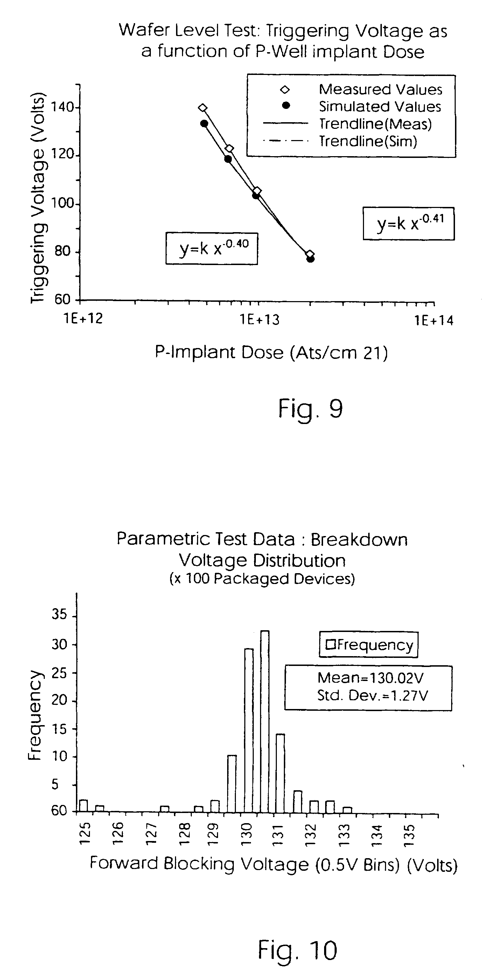

Referring now to Figs. 9 and 10, experimental results are illustrated. Fig. 9 shows that there is a clearly defined and predictable relationship between the triggering voltage V_{BF} and the p- implant dose (lateral first region 20). Fig. 10 shows that there is a low standard deviation for forward blocking voltage across 100 packaged devices. These plots illustrate the level of control which is achieved, thereby providing for simpler and less expensive breakover diode production.

The invention is not limited to the embodiments described and may be varied in construction and detail within the scope of the claims In another embodiment, the thyristor structure is reversed such that the layers 10, 11, 12, and 13 become and n+ anode emitter, a p- base layer, an n+ base layer, and a p+ emitter layer respectively. In this embodiment the auxiliary junction regions are reversed in which the n+ region becomes a p+ region and the p- region becomes an n- region. Also, the relative doping concentrations may be different in which case breakdown may be controlled to some extent by geometry of the diode. The thyristor may have more than four layers and the second lateral region may be fabricated on a layer of a different doping type. The lateral regions need not be at the centre of the diode as illustrated and may be fabricated at any other lateral location according to masking.

## Claims

1. A breakover diode comprising a vertical layer thyristor structure between an anode and a cathode. characterised in that the diode further comprises a lateral auxiliary junction formed by a lateral first region adjoining a thyristor layer having the same doping type, and a lateral second region adjoining the first region and being of the other doping type, the doping of the auxiliary junction being such that avalanche breakdown occurs firstly at the auxiliary junction.

2. A breakover diode as claimed in claim 1, wherein the auxiliary junction forms a current path at breakdown linking the central layers of the thyristor.

3. A breakover diode as claimed in claim 2, wherein the second region of the auxiliary junction adjoins a thyristor layer of the same doping type.

4. A breakover diode as claimed in claim 3, wherein the first region has a lower doping level than the adjoining thyristor layer.

5. A breakover diode as claimed in claims 3 or 4, wherein the second region has a higher doping level than the adjoining thyristor layer.

6. A breakover diode as claimed in any preceding claim, wherein the first and second regions are fabricated on an n- thyristor layer, the first region has p-doping, and the second region has n+ doping.

7. A breakover diode as claimed in claim 6, wherein the lateral first region has a doping concentration in the range of 1 x 10¹² to 1 x 10¹⁷/cm³ and the lateral second region has a doping concentration in the range of 1 x 10¹⁶ to 1 x 10²²/cm³.

8. A method of producing a breakover diode comprising the steps of:-
providing a doped substrate as a thyristor layer; and
fabricating vertical layers on the substrate to form a vertical thyristor structure, and lateral regions to form an auxiliary junction adjoining two or more thyristor layers, the lateral regions being doped to breakdown before junctions in the thyristor structure.

9. A method as claimed in claim 8, wherein the lateral first and second regions are fabricated on the substrate thyristor layer.

10. A method as claimed in claims 8 or 9, wherein the lateral regions comprise a first region adjoining a thyristor layer having the same doping type and a seond region adjoining the first region and being of the other doping type.

11. A method as claimed in any of claims 8 or 10, wherein the substrate is a central thyristor layer.

12. A method as claimed in any of claims 8 to 11, wherein the lateral first region is fabricated independently.

13. A method as claimed in claim 12, wherein the lateral second region is fabricated together with a cathode emitter layer of the thyristor.

14. A method as claimed in claim 13, wherein the lateral second region has the same doping type and concentration as the cathode emitter layer.
